Europäisches Patentamt

European Patent Office

Office européen des brevets

(19)

(11) Numéro de publication: **0 035 453**
**A1**

(12) **DEMANDE DE BREVET EUROPEEN**

(21) Numéro de dépôt: **81400311.7**

(22) Date de dépôt: **27.02.81**

(51) Int. Cl.³: **H 01 L 27/08**, H 01 L 29/78, H 01 L 27/06, H 03 K 19/08

(30) Priorité: **04.03.80 FR 8004834**

(43) Date de publication de la demande: **09.09.81**
**Bulletin 81/36**

(84) Etats contractants désignés: **DE FR GB IT NL**

(71) Demandeur: **THOMSON-CSF, 173, Boulevard Haussmann, F-75360 Paris Cedex 08 (FR)**

(72) Inventeur: **Moreau, Jean-Michel, THOMSON-CSF SCPI 173, bld Haussmann, F-75360 Paris Cedex 08 (FR)**

(74) Mandataire: **de Beaumont, Michel et al, "THOMSON-CSF" SCPI 173, Bld Haussmann, F-75360 Paris Cedex 08 (FR)**

(54) Structure de transistor à effet de champ à grille isolée, et application à une réalisation de portes logiques.

(57) La présente invention concerne une structure de transistors à effet de champ à grille isolée.

Cette structure comprend dans une couche épitaxiale 40, une région diffusée 41 de type P et des zones 42 et 43 diffusées à l'intérieur de cette région 41. Une électrode de source est solidaire de la couche épitaxiée 40 et des électrodes de drain $D_1$, $D_2$ des zones diffusées de type N+ 42 et 43. On obtient ainsi un transistor multi-drains. En outre, chaque drain peut être associé à plusieurs électrodes de grilles $G_1$, $G_2$.

Application à la réalisation de circuits logiques en association avec des structures bipolaires haute tension.

STRUCTURE DE TRANSISTOR A EFFET DE CHAMP A GRILLE ISOLEE ET
APPLICATION A UNE REALISATION DE PORTES LOGIQUES.

La présente invention concerne une structure de transistor à effet de champ à grille isolée obtenue par diffusion et l'association de tels transistors pour former des portes logiques sur des plaquettes de circuits intégrés portant également des composants de type bipolaire ou autre. On s'intéressera tout particulièrement ici au cas où, parmi ces composants bipolaires, certains au moins doivent supporter des tensions élevées, supérieures à une trentaine de volts.

Dans la suite du texte, on désignera par le sigle TECGID un transistor à effet de champ à grille isolée obtenu par diffusion. On notera que des transistors de structures voisines sont couramment désignés également dans la technique par l'appellation d'origine anglo saxonne DMOS.

Dans le domaine des circuits intégrés, on cherche souvent à réaliser sur une plaquette unique un circuit comprenant notamment des composants pouvant supporter une puissance et une tension relativement élevées et des composants permettant d'assurer diverses fonctions logiques. Les composants pouvant supporter des tensions à puissance relativement importante sont généralement des circuits intégrés linéaires du type bipolaire dont l'une des caractéristiques est de comprendre un substrat semiconducteur, couramment du silicium d'un premier type de conductivité, sur lequel est formée une couche épitaxiée du type de conductivité opposé, la couche épitaxiée étant divisée en caissons par des murs d'isolement de même type que le substrat. Dans chacun de ces caissons est formé un composant élémentaire ou un ensemble de composants élémentaires interconnectés.

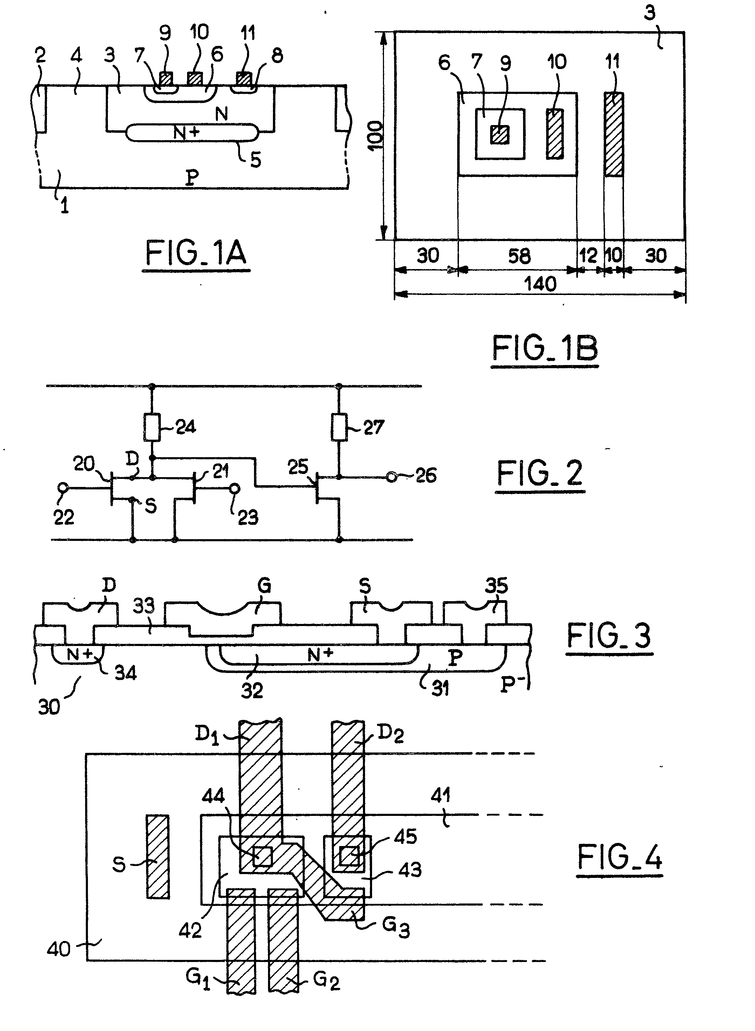

Les figures 1A et 1B rappellent la structure connue d'un transistor bipolaire disposé dans un caisson d'une plaquette de circuit intégré. La plaquette comprend un substrat 1 de type P sur lequel est formée une couche épitaxiée 2. Un caisson 3 comprenant une partie de la couche épitaxiée 2 est limité par des murs d'isolement 4 de type P. Au fond du caisson se trouve une couche enterrée 5 de type $N^+$. Dans le caisson est diffusée localement une couche 6 de type P puis, ensuite, des zones de type $N^+$, 7 et 8, respectivement à l'intérieur de la couche 6 de type P et à l'intérieur de la couche épitaxiée 3. Des métallisations 9, 10 et 11 solidaires respectivement des couches 7, 6 et 8 constituent respectivement des bornes d'émetteur, de base et de collecteur pour le transistor. La figure 1B dans laquelle de mêmes zones sont désignées par de mêmes références qu'en figure 1A représente une vue de dessus du caisson 3 de cette figure 1A. Alors que la figure 1A était une figure fortement schématique, la figure 1B représente à l'échelle un mode réalisation de transistor bipolaire avec un dimensionnement réaliste. Les cotes ont été indiquées en microns. On voit que le caisson occupe une dimension de l'ordre de 100 x 140 microns, ce qui constitue sensiblement les dimensions minimales à l'heure actuelle pour des réalisations industrielles.

L'un des aspects qu'il convient de souligner sur ces transistors bipolaires est que, plus la tension que doivent supporter ces composants est élevée, plus l'épaisseur du caisson doit être importante, par exemple supérieure à une dizaine de microns, plus le niveau de dopage de cette couche épitaxiée doit être faible, par exemple inférieure à $10^{15}$ at/cm$^3$, et plus la distance entre la partie active et le mur d'isolement doit être grande.

Pour réaliser une structure logique sur une plaquette de circuit intégré comprenant des transistors bipolaires tels que ceux des figures 1A et 1B, il convient bien entendu d'utiliser des composants dont la technologie soit compatible avec celle de ces transistors bipolaires. La solution la plus évidemment compatible consiste à utiliser des transistors bipolaires analogues. Mais alors, on se trouve obligé, pour fabriquer un circuit logique, d'utiliser un grand nombre de transistors bipolaires réalisés individuellement dans des caissons, c'est-à-dire que cette structure logique occupera une dimension importante comme le fait ressortir la figure 1B, et ceci en grande partie à cause de l'intervalle important obligatoire entre les diffusions de base et d'émetteur et le mur d'isolement.

L'une des technologies connue et mise en oeuvre pour fournir des structures logiques sur des plaquettes de circuits intégrés de façon compatible avec des transistors bipolaires est connue sous l'appellation $I^2L$. On pourra trouver par exemple quelques notions sur cette structure dans l'ouvrage de H. Lilen intitulé "circuits intégrés linéaires", pages 63-65, 4ème édition, paru aux éditions Radio en 1978. Cette technologie permet notamment d'obtenir des transistors multicollecteurs à l'intérieur d'un même caisson. Néanmoins, dans le cas où la couche épitaxiée voit son niveau de dopage diminuer, c'est-à-dire dans le cas évoqué ci-dessus où certains au moins des transitors bipolaires du circuit intégré doivent supporter une tension importante, les transistors de type $I^2L$ commencent à mal fonctionner. Il est donc alors souhaitable de rechercher une autre technologie compatible avec des circuits intégrés bipolaires et avec un niveau de dopage relativement faible de la couche épitaxiée.

C'est là l'un des principaux objets de la présente invention.

Pour atteindre cet objet, la présente invention prévoit une structure de transistors TECGID formée dans un caisson d'une plaquette de circuit intégré comprenant des transistors bipolaires haute tension et éventuellement d'autres composants de la technologie bipolaire ou compatibles avec celle-ci, cette plaquette portant, sur un substrat d'un premier type de conductivité, une couche épitaxiée d'un deuxième type de conductivité d'un niveau de dopage inférieur à $10^{15}$ at/cm³. Dans cette structure, la source de ces transistors TECGID est commune et est constituée par la couche épitaxiée ; une couche intermédiaire du premier type de conductivité est formée dans cette couche épitaxiée ; les drains de ces transistors TECGID sont constitués de régions distinctes du deuxième type de conductivité formées dans la couche intermédiaire ; et des métallisations de grille isolées sont formées au-dessus de portions superficielles de la couche intermédiaire, sensiblement entre les limites en regard des régions de drain et de la région de source. Selon un aspect de l'invention, au moins deux métallisations de grilles, commandables de façon distinctes, peuvent être formées entre une zone de drain et la zone de source.

Une structure selon la présente invention peut notamment s'appliquer à la formation d'un ensemble d'inverseurs logiques à partir desquels on pourra réaliser simplement toutes les fonctions logiques souhaitées de deux ou plusieurs variales d'entrée. Une porte NON OU (NI) à deux entrées en logique positive, sera constituée d'une structure selon la présente invention comprenant une première zone de drain et deux métallisations de grilles correspondant aux deux entrées de la porte associées à cette zone. Une porte OU comprendra une zone de drain supplémentaire, la métallisation de grille associée à cette deuxième zone de drain étant connectée à (ou commune avec) la métallisation de la première zone de drain, et la métallisation de la seconde zone de drain correspondant à la sortie de la porte OU.

On peut ainsi obtenir des ensembles de portes logiques de petites dimensions à l'intérieur d'un même caisson de circuit intégré bipolaire, les dimensions de cet ensemble de portes logiques étant par exemple du même ordre de grandeur que celles qu'on pourrait obtenir en utilisant la technologie $I^2L$.

Ces objets, caractéristiques et avantages ainsi que d'autres de la présente invention seront exposés plus en détail dans la description suivante de modes de réalisation particuliers faite en relation avec les figures jointes parmi lesquelles :

les figures 1A et 1B représentent un transistor bipolaire classique et ont été décrites précédemment en relation avec l'état de la technique ;

la figure 2 représente un schéma de circuit constituant une porte OU ;

la figure 3 représente en coupe une structure de transistor à effet de champ à grille isolée obtenu par diffusion (TECGID); et

la figure 4 représente en vue de dessus une structure de transistors TECGID selon la présente invention.

La figure 2 représente le schéma d'un circuit logique élémentaire constituant une porte OU. Ce circuit logique élémentaire comprend deux transistors 20 et 21 dont les collecteurs (s'il s'agit de transistors bipolaires) ou les drains (s'il s'agit de transistors à effet de champ) sont interconnectés, dont les émetteurs ou sources sont reliés à la masse et dont les bases ou grilles 22 et 23 reçoivent des signaux d'entrée $E_1$ et $E_2$. Les collecteurs ou drains sont reliés à la borne d'alimentation positive par l'intermédiaire d'une charge 24. Ce premier ensemble réalise par rapport aux signaux d'entrée $E_1$ et $E_2$ une fonction NON OU. La borne commune de collecteur ou de drain est reliée à la borne de base ou de grille d'un autre transistor 25 dont l'émetteur ou source est relié à la masse (ou borne d'alimentation négative) et dont le collecteur ou drain constitue la borne de sortie 26. Le collecteur ou drain est relié à la borne d'alimentation positive par l'intermédiaire d'une charge 27. Pour réaliser un tel circuit sous forme bipolaire, les deux transistors 22 et 23 pourront être réalisés dans un même caisson et le transistor 25 devra être réalisé dans un caisson distinct, ce qui entraîne la nécessité de prévoir de nombreux caissons si l'on veut réaliser des fonctions logiques complexes de plusieurs variables.

La figure 3 rappelle la structure connue d'un transistor à effet de champ à grille isolée obtenu par diffusion ou TECGID, également désigné dans la technique par le sigle DMOS. Un exposé général de la structure des transistors MOS à double diffusion DMOS est donné par exemple dans l'ouvrage de H. Lilen intitulé "circuits intégrés JFET-MOS-CMOS" pages 101-104, 3ème édition, paru aux Editions Radio en 1979. Sur un substrat 30 de type $P^-$ est formée une région 31 du même type de conductivité P mais à plus fort niveau de dopage à l'intérieur de laquelle est formée une région 32 du type de conductivité opposé, $N^+$, et à niveau de dopage élevé. La référence 33 désigne une couche d'un matériau isolant, dans la pratique courante de l'oxyde de silicium. Une électrode de drain D est solidaire d'une région $N^+$ 34 formée dans le substrat. Une électrode de source S est solidaire de la couche 32, et une électrode de grille G est formée au-dessus d'une partie de la couche intermédiaire 31 de façon à y former un canal de conduction quand une tension est appliquée. Il est en outre souvent prévu une métallisation supplémentaire 35 solidaire de la couche intermédiaire 31 pour permettre une polarisation éventuelle de cette couche, par exemple par connexion entre la métallisation 35 et la métallisation de source S. L'un des avantages souvent mis en exergue des dispositifs de type DMOS représentés en figure 3 réside dans le fait que la largeur de la zone de canal peut être d'une valeur faible, contrôlée avec une grande précision par des techniques d'auto-alignement des diffusions successives P et $N^+$.

On s'intéressera ici à des structures de ce type essentiellement en raison du fait qu'elles sont compatibles dans leur technologie de fabrication avec des procédés utilisés pour la fabrication de transistors bipolaires sur des plaquettes de circuits intégrés. En effet, si on compare les figures 3 et 1A, on peut voir qu'il n'y a pas une grande différence de structure en ce qui concerne les couches formées dans le semiconducteur entre un composant de type bipolaire et un composant de type DMOS, en remplaçant dans le composant de type DMOS le substrat de type $P^-$ par la couche épitaxiée de type N de la figure 1A.

Un aspect de la présente invention réside dans le fait qu'au lieu d'utiliser un transistor TECGID tel que celui de la figure 3 avec une métallisation de drain sur le substrat et une métallisation de source sur la couche diffusée $N^+$ 32, ces métallisations sont inversées et l'on utilise comme source la métallisation solidaire de la couche épitaxiée et comme drain la métallisation solidaire de la couche diffusée 32. Ceci va à l'encontre d'un préjugé établi dans la technique car le fait d'inverser la source et le drain entraîne une perte de tenue en tension, une augmentation de la résistance à l'état passant et une diminution de l'impédance dynamique de sortie. Mais, pour une application à des circuits logiques envisagée dans la présente invention, ces inconvénients sont négligeables devant le gain de surface important apporté par la possibilité d'utiliser des transistors TECGID dans un caisson commun plutôt que des transistors bipolaires dans des caissons distincts.

La figure 4 représente un mode de réalisation d'une porte logique OU selon le circuit de la figure 2 avec la technologie selon l'invention. Sur un substrat de type N 40 qui correspond à la couche épitaxiée 2 de la figure 1A, on forme une couche intermédiaire diffusée de type P 41 puis, à l'intérieur de cette diffusion P 41, on forme plusieurs couches diffusées de type $N^+$ 42, 43. Une métallisation de source commune S est prise sur la couche 40, cette métallisation étant reliée au potentiel négatif d'alimentation. Des métallisations $D_1$ et $D_2$ sont solidaires des couches 42 et 43 par l'intermédiaire de zones de contact 44 et 45. Et des métallisations de grille $G_1$, $G_2$ et $G_3$ correspondent aux bornes respectivés 22, 23 et 26 de la figure 2. La métallisation $G_3$ est solidaire de la métallisation $D_1$ comme le montre le schéma de la figure 2. On notera que, selon un aspect de la présente invention, la commande du transistor dont le drain est constitué par la couche 42 peut être assurée par l'une ou l'autre des grilles $G_1$ et $G_2$. On a ainsi obtenu un transistor à source commune à drain unique et à plusieurs grilles. On obtient également selon un autre aspect de l'invention, un transistor à source commune et à plusieurs drains 42, 43.

La présente invention permet donc la fourniture de transistors à source commune multidrains et/ou multigrilles.

Les pointillés s'étendant à la droite de la figure 4 indiquent qu'il est possible de multiplier le nombre de drains diffusés à l'intérieur de la couche intermédiaire 41. De même, il serait possible de multiplier le nombre de grilles correspondant à la couche de drain 42.

Les éléments de charge reliant chaque drain au pôle positif de l'alimentation peuvent être d'un type déjà connu : résistance diffusée ou implantée, source de courant à transistor PNP latéral, transistor MOS canal P à appauvrissement, transistor MOS canal N à enrichissement, etc... Dans ce dernier cas, les éléments de charge peuvent être des transistors MOS du type DMOS polarisés cette fois normalement (substrat correspondant au drain et régions diffusées $N^+$ correspondant à la source) et placés tous dans un même caisson d'isolement.

En revenant sur les figures 2 et 4, on pourra considérer l'invention comme concernant une structure particulière d'inverseur logique, constituée d'un transistor dont la source est con-

8

nectée à une borne de polarisation négative et dont le drain, qui constitue la borne de sortie, est connecté par l'intermédiaire d'une charge à une borne de polarisation positive ; cet inverseur pouvant être associé de façon particulièrement simple à d'autres inverseurs logiques de même type pour former diverses sortes de portes logiques NON OU, OU, OU exclusif, NON ET, ET, ... et diverses associations de ces portes ; le circuit logique complexe résultant occupant une faible surface de semiconducteur en raison de la disposition à source commune unique.

La présente invention n'est pas limitée aux modes de réalisation qui ont été explicitement décrits, elle en comprend les diverses variantes et généralisations incluses dans le domaine des revendications ci-après.

REVENDICATIONS.

1. Structure de transistors à effet de champ à grille isolée obtenue par diffusion formée dans un caisson épitaxié d'une plaquette de circuit intégré, reliée à une source de polarisation comprenant des transistors bipolaires haute tension et éventuellement d'autres composants de technologie compatible, cette couche épitaxiée ayant un niveau de dopage inférieur à $10^{15}$ at/cm$^3$, caractérisée en ce que ces transistors ont une source commune (S) constituée par la couche épitaxiée (40) et reliée à la borne négative gative de la source de polarisation du circuit, une couche intermédiaire (41) de type de conductivité opposé étant formée dans cette couche épitaxiée, les drains ($D_1$, $D_2$,...) de ces transistors étant constitués de régions distinctes (42, 43) du même type de conductivité que la couche épitaxiée formées dans la couche intermédiaire, et des métallisations de grilles isolées étant formées au-dessus de portions superficielles de la couche intermédiaire sensiblement entre les limites des régions de drains et de la région de source.

2. Structure de transistors selon la revendication 1, caractérisée en ce que chaque transistor constitue un inverseur logique dont la grille constitue l'entrée et dont le drain, connecté à la borne positive de la source de polarisation, constitue la sortie.

3. Structure selon la revendication 1, caractérisée en ce qu'au moins deux métallisations de grilles ($G_1$, $G_2$) sont formées entre une zone de drain et la zone de source.

4. Structure selon la revendication 3, constituant une porte logique NON OU à au moins deux entrées, caractérisée en ce qu'elle comprend un drain et au moins deux métallisations de grille associées à ce drain, chaque métallisation de grille correspondant à une entrée et la métallisation de drain correspondant à la sortie.

5. Structure selon la revendication 4, constituant une porte logique OU caractérisée en ce qu'elle comprend une autre zone de drain (43) associée à une autre métallisation de grille (G$_3$), solidaire de la métallisation de drain (D$_1$) de la porte NON OU.

6. Circuit intégré comprenant des éléments logiques ayant des structures selon l'une quelconque des revendications 1 à 5.

FIG_1A

FIG_1B

FIG_2

FIG_3

FIG_4

0035453

1 / 1

**Office européen**
**des brevets**

**RAPPORT DE RECHERCHE EUROPEENNE**

EP 81 40 0311

| | **DOCUMENTS CONSIDERES COMME PERTINENTS** | | **CLASSEMENT DE LA DEMANDE (Int. Cl.³)** |
|---|---|---|---|
| Catégorie | Citation du document avec indication, en cas de besoin, des parties pertinentes | Revendica-tion concernée | |
| | DE - A - 2 050 955 (HITACHI LTD)<br><br>  * Figures 1-9,12-14, 20; page 4, dernier paragraphe - page 11, paragraphe 2, page 13, paragraphe 2 - page 14 *<br><br>      -- | 1-6 | H 01 L 27/08<br>          29/78<br>          27/06<br>H 03 K 19/08 |
| | GB - A - 1 400 574 (SONY CORP.)<br><br>  * Figure 5; page 5, lignes 3-105 *<br><br>      -- | 1 | |
| | US - A - 3 923 553 (Y. HAYASHI et al.)<br><br>  * Figures 5-7; colonne 3, ligne 24 - colonne 4, ligne 46 *<br><br>      -- | 1 | **DOMAINES TECHNIQUES RECHERCHES (Int. Cl.³)**<br><br>H 01 L 27/08<br>          29/78<br>H 03 K 19/08<br>H 01 L 27/06 |
| | FR - A - 2 411 512 (LARDY et al.)<br><br>  * Figures 1-9; page 3, ligne 28; page 11, ligne 34 *<br><br>      ---- | 1-6 | |
| | | | **CATEGORIE DES DOCUMENTS CITES**<br><br>X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cité pour d'autres raisons<br><br>&: membre de la même famille, document correspondant |

Le présent rapport de recherche a été établi pour toutes les revendications

| Lieu de la recherche | Date d'achèvement de la recherche | Examinateur |
|---|---|---|
| La Haye | 26-05-1981 | CARBON |